# EUROPEAN PATENT SPECIFICATION

(11) **EP 4 346 104 B1**
(45) Date of publication and mention of the grant of the patent: **28.10.2026**
(21) Application number: 23196935.3
(22) Date of filing: 12.09.2023
(51) Int. Cl.: H03K 19/00, G06F 1/26, G06F 1/3287

(54) **DUAL LOW-POWER HIGH-POWER MODE VOLTAGE REGULATOR WITHOUT EXTERNAL COMPENSATION**
DUALER SPANNUNGSREGLER MIT NIEDRIGER LEISTUNG UND HOHER LEISTUNG MODUS OHNE EXTERNE KOMPENSATION
RÉGULATEUR DE TENSION DOUBLE MODE À FAIBLE PUISSANCE ET À HAUTE PUISSANCE SANS COMPENSATION EXTERNE

(30) Priority: 27.09.2022 US 202263377219 P; 10.07.2023 US 202318220166
(43) Date of publication of application: 03.04.2024
(73) Proprietor: Analog Devices International Unlimited Company, Limerick (IE)
(72) Inventor: Gomez, Jose Tejada, Limerick (IE); Iriarte, Santiago, Limerick (IE); Salvador, Ruben, Limerick (IE)
(74) Representative: Horler, Philip John

(56) References cited:
- US-A1- 2011 084 552
- US-A1- 2014 351 615
- US-A1- 2015 162 055
- US-B1- 9 343 966

## Description

### FIELD OF THE DISCLOSURE

This document pertains generally, but not by way of limitation, to electronic circuits, and more particularly, to power-gated electronic circuits.

### BACKGROUND

Electronic systems can include devices that require a regulated power source. As electronic systems continue to evolve, they require more complexity in a smaller size. The increase in complexity can come at the cost of increased power dissipation. Some electronic systems seek to reduce the power required during the time when the system is idle. However, some circuit functionality is still required even when the electronic system is in an idle or sleep mode. The electronic systems can include digital subsystems. Digital subsystems consumer power mainly due to logic switching of the digital circuits. Power used by the digital subsystem can be reduced by stopping the clock to the portion of the circuits not needed in the sleep mode. However, there is still a power drain from the circuits due to leakage while the clock is frozen.

Another approach to reducing power in a sleep mode is to remove power from the portion of the circuits not used in the sleep mode. This can be done by dividing the power supply to the circuits into multiple supply domains. One supply domain can be turned off in the low power idle mode and one supply domain can be turned on in the low power idle mode to provide supply power to the circuits active in the idle mode. However, having multiple supply domains presents challenges in keeping the size of the electronic system small. Switches to enable and disable separate supply domains need to be robust and can take up a large amount of area. Also, the supply domains need to be connected to external capacitors to filter one or more of the supply domains.

US 2014/351615 A1 discloses an integrated circuit including high and low power regulators, first and second sets of circuits and a switch connecting the high-power regulator and the second set of circuits. A control system enables the high-power regulator in a high-power mode and enables the low-power regulator in a low-power mode.

US 2011/084552 discloses a power management system with two selectable power modes. The system includes two regulators operating in two voltage domains. A switch is disposed between the regulator outputs to selectively interconnect the regulators in dependence on the power mode.

US 9343966 B1 discloses a voltage switching system operable in first and second operational modes. The system includes first and second voltage regulators and performs a hand-over operation, in which the operation of the regulators is modified.

### BRIEF DESCRIPTION OF THE DRAWINGS

In the drawings, which are not necessarily drawn to scale, like numerals may describe similar components in different views. Like numerals having different letter suffixes may represent different instances of similar components. The drawings illustrate generally, by way of example, but not by way of limitation, various embodiments discussed in the present document.
FIG. 1 is a schematic of an example of a circuit with power gating.
FIG. 2 is a schematic of an example of a circuit with multiple supply domains.
FIG. 3 is a flow diagram of an example of a method of operating a circuit supply of an electronic system.

### DETAILED DESCRIPTION

Electronic systems may implement a low power sleep mode to reduce power consumption. In a low power sleep mode, some circuits of the electronic system are disabled to conserve the energy consumed by their operation. The unused circuits can be disabled by removing power from the circuits. The circuit supply for the system can be divided into multiple supply domains. One supply domain is turned on in the low power sleep mode to provide power to the circuits needed in the sleep mode, while other supply domains can be turned off. When the system exits the sleep mode to an active mode, all supply domains are turned on.

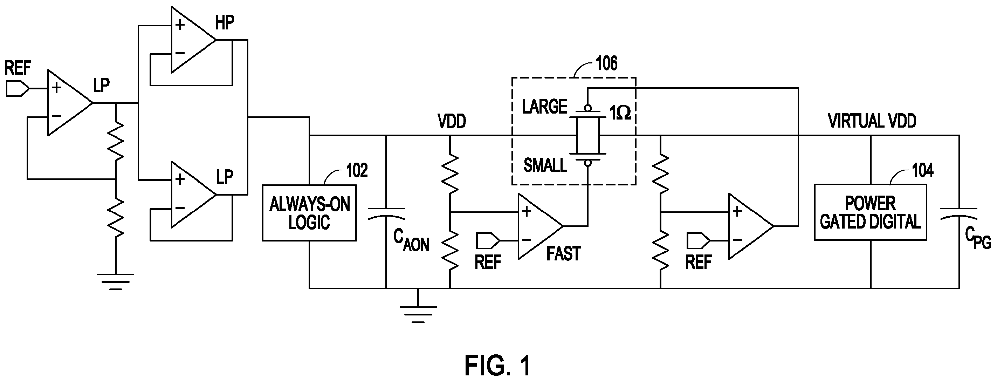

One approach to managing multiple supply domains is to use power gating techniques. FIG. 1 is a schematic of an example of a circuit with power gating. The circuit has two circuit supply domains (or circuit supply rails) VDD and virtual VDD. The VDD supply domain provides energy to the lower power always-on digital logic 102 and the virtual VDD supply domain provides energy to the higher power gated digital logic 104 when the virtual VDD supply domain is turned on. The gated digital logic 104 includes most of the digital circuitry and can include one or more processors and memories. The circuitry included in the always-on digital logic 102 is minimized to reduce the power needed. The always-on digital logic 102 includes logic used to detect the condition for activating the gated digital logic 104.

To turn on the virtual VDD supply domain, a switch 106 is arranged between the VDD domain and the virtual VDD domain. The switch 106 is enabled when the circuit exits the sleep mode and enters the active mode. In the approach of FIG. 1, a single supply rail is used, and the single supply rail is gated to the higher power gated digital logic 104 using a switch 106 that is in series with the VDD domain and the higher power gated digital logic 104. The current requirements of the gated digital logic 104 may require that the switch 106 needs to be large to have a low impedance to transfer a large amount of current from the VDD supply domain to the virtual VDD supply domain without a voltage drop between the VDD supply domain and the virtual VDD supply domain.

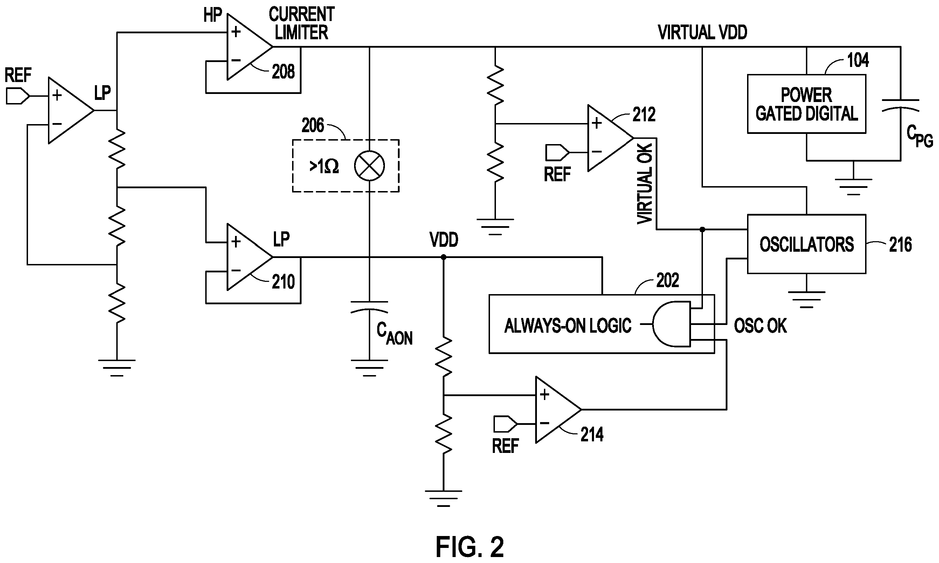

FIG. 2 is a schematic of another example of a circuit with multiple supply domains. The circuit includes Low Drop Out regulator circuits (LDOs). An LDO regulator is a direct current (DC) regulator that can provide a regulated output voltage even when the input voltage to the LDO is close to the output voltage of the LDO. The circuit example of FIG. 2 includes two LDO regulators. One LDO is a higher power (HP) regulator 208 with higher drive capability and the other is a (LP) regulator 210.

The circuit in FIG. 2 has two supply domains VDD and virtual VDD, but the virtual VDD domain is not gated from the VDD domain. The virtual VDD supply domain is directly connected to the HP regulator 208, and the HP regulator 208 is not connected to the virtual VDD supply domain through a switch as in the example of FIG. 1. The VDD supply domain is directly connected to the LP regulator 210. The circuit also includes a small switch circuit 206 connecting the output of the HP regulator 208 to the LP regulator 210 and the VDD supply domain to the virtual VDD supply domain.

The circuit in FIG. 2 includes higher power gated digital circuitry 104 and lower power always-on circuitry 202. The always-on circuitry 202 includes control logic to configure the circuit 200 in a sleep mode and an active mode, and detection circuitry to detect a condition for entering the active mode or the sleep mode. In the low power sleep mode, the HP regulator 208 is turned off. The virtual VDD supply domain and the gated digital circuitry 104 are also off. The LP regulator 210 provides a regulated circuit supply to the VDD supply domain to power the always-on circuitry 202. The circuit 200 can include a fault detection circuit 214 that is also always-on, such as to detect a low battery condition. The oscillator circuitry 216 is also off in the sleep mode.

In the active mode, the HP regulator 208 is turned on. The higher power gated digital logic 104 is active and is powered directly by the HP regulator 208. The switch circuit 206 is turned on in the active mode and the always-on circuitry 202 operates using the output from the HP regulator 208. The LP regulator 210 may remain turned on in the active mode. In variations, the LP regulator 210 is turned off in the active mode.

Because the switch circuit 206 is not arranged in series with the higher power gated digital circuitry 104 and the HP regulator 208, there is much less current across it than across the switch 106 in the circuit of FIG. 1. Because the current across the switch circuit 206 is much smaller, the size of the switch circuit 206 can be much smaller (e.g., 10-30 times smaller) than the switch 106 in the circuit of FIG. 1. In some examples, the switch circuit 206 has an internal resistance of approximately one ohm (1Ω). Also, because the current across the switch circuit 206 is small, the switch circuit 206 could also have a relatively high impedance (e.g., 100 ohms) but still have a small enough voltage drop for the circuit to still work properly.

During the transition from sleep mode to active mode, the HP regulator 208 is turned on and the switch circuit 206 is initially still off. The voltage of the virtual VDD supply domain rises independently of the VDD supply domain. The circuit 200 includes a comparator 212 to detect when the virtual VDD supply domain reaches a predetermined threshold voltage. In some examples, the predetermined threshold voltage can be equal to a digital reset voltage level. In some examples, the predetermined threshold voltage is the voltage of the LP regulator 210. When the virtual VDD supply domain reaches the predetermined threshold voltage, the switch circuit 206 can be turned on. After being turned on, the HP regulator 208 may take over regulation of the VDD supply domain as well as the virtual VDD supply domain.

When returning to the sleep mode, the control logic of the always-on circuitry 202 may disable the gated digital circuitry 104 first before disabling the switch circuit 206. The control logic may disable the switch circuit 206 before disabling the HP regulator 208.

Both the circuits of FIG. 1 and FIG. 2 include a decoupling capacitor C_{AON} to prevent droop in the VDD supply domain during switching. However, because the VDD supply domain is isolated from the virtual VDD supply domain during the transition to active mode until the virtual VDD supply domain reaches the predetermined threshold voltage, the decoupling capacitor in FIG. 2 can be smaller than in the circuit of FIG. 1. The larger capacitor of the circuit of FIG. 1 may need to be an external capacitor that is external to the integrated circuit (IC) die containing the circuit of FIG. 1 and the circuit needs to have an external connection to the external capacitor. Because the capacitor in the circuit of FIG. 2 is smaller, the decoupling capacitor can be internal to the circuit and the circuit of FIG. 2 can be used with regulator circuits that have only internal decoupling capacitors that are internal to the IC containing the circuit. The much smaller sized switch 206 and the smaller decoupling capacitance results in a circuit that can be much smaller than the power gating approach of the circuit of FIG. 1.

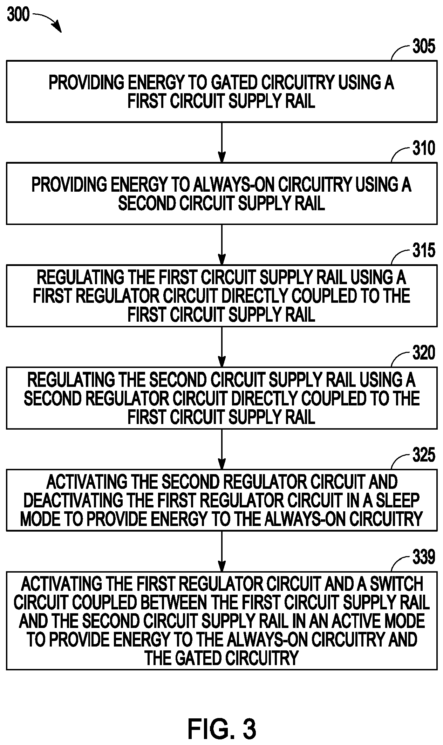

For completeness, FIG. 3 is a flow diagram of an example of a method 300 of operating a circuit supply of an electronic system. At block 305, energy is provided to gated circuitry using a first circuit supply rail. At block 310, energy to always-on circuitry using a second circuit supply rail. The always-on circuitry uses less power than the gated circuitry.

At block 315, the first circuit supply rail is regulated using a first regulator circuit directly coupled to the first circuit supply rail. The first regulator circuit maybe a HP regulator circuit. At 320, the second circuit supply rail is regulated using a second regulator circuit directly coupled to the first circuit supply rail. The second regulator circuit may be a low power regulator circuit.

At block 325, the first regulator circuit is deactivated, and the second regulator circuit is activated in a sleep mode to provide energy to the always-on circuitry in the sleep mode. At block 330, the first regulator circuit and a switch connected between the outputs of the first and second regulator circuits are activated in active mode to provide energy to the gated circuitry and the always-on circuitry in the active mode.

The method has many applications. For example, the always-on circuitry could detect the output of a capacitive sensor for a display screen (e.g., a touch sensitive display of a smartphone). The control logic of the always-on circuitry could deactivate the gated circuitry and place the device in a sleep mode when a timer of the gated circuitry times out due to no interaction of a user with the display screen. The always-on circuitry could place thse device in active mode in response to output from the capacitive sensor indicating user interaction with the display screen. The circuit implementing the method can have a small size due to the small size of the switch needed between the circuit supply rails and the reduced decoupling capacitance needed.

Method examples described herein can be machine or computer-implemented at least in part. Some examples can include a computer-readable medium or machine-readable medium encoded with instructions operable to configure an electronic device to perform methods as described in the above examples. An implementation of such methods can include code, such as microcode, assembly language code, a higher-level language code, or the like. Such code can include computer readable instructions for performing various methods. The code may form portions of computer program products. Such instructions can be read and executed by one or more processors to enable performance of operations comprising a method, for example. The instructions are in any suitable form, such as but not limited to source code, compiled code, interpreted code, executable code, static code, dynamic code, and the like.

Further, in an example, the code can be tangibly stored on one or more volatile, non-transitory, or non-volatile tangible computer-readable media, such as during execution or at other times. Examples of these tangible computer-readable media can include, but are not limited to, hard disks, removable magnetic disks, removable optical disks (e.g., compact disks and digital video disks), magnetic cassettes, memory cards or sticks, random access memories (RAMs), read only memories (ROMs), and the like.

## Claims

1. An electronic system, the system comprising:
gated circuitry (104);
a first regulator circuit (208) directly coupled to the gated circuitry (104);
always-on circuitry (202);
a second regulator circuit (210) directly coupled to the always-on circuitry (202);
a switch circuit (206) coupled between an output of the first regulator circuit (208) and an output of the second regulator circuit (210); and
wherein the always-on circuitry (202) includes control logic configured to:
activate the second regulator circuit (210) and deactivate the first regulator circuit (208) and the switch circuit (206) in a sleep mode; and
activate the first regulator circuit (208) and the switch circuit (206) in an active mode,
**characterized in that**
the always-on circuitry (202) is configured to, when entering the sleep mode from the active mode, disable the gated circuitry (104) before disabling the switch circuit (206) and disable the switch circuit (206) before deactivating the first regulator circuit (208).

2. The electronic system of claim 1, including:
detection circuitry (212) that detects when an output of the first regulator circuit (208) reaches a predetermined threshold voltage after activation of the first regulator circuit (208) in the active mode; and
wherein the always-on circuitry (202) is configured to activate the switch circuit (206) when the predetermined threshold voltage is reached.

3. The electronic system of any preceding claim,
wherein the first regulator circuit (208) generates a regulated voltage for a first circuit supply domain of the electronic system and gated circuitry (104) is supplied by the first circuit supply domain; and
wherein the second regulator circuit (210) generates a regulated voltage for a second circuit supply domain of the electronic system and the always-on circuit (202) is supplied by the second circuit supply domain in the sleep mode and by the first circuit supply domain in the active mode.

4. The electronic system of claim 3, wherein the first regulator circuit (208) is directly coupled to the first circuit supply domain without a power switch between the first regulator circuit (208) and the first circuit supply domain.

5. The electronic system of any preceding claim, wherein the switch circuit (206) has an internal resistance of one ohm, or wherein the switch circuit (206) has an internal resistance in the range of one ohm to one hundred ohms.

6. The electronic system of any preceding claim including:
a decoupling capacitor connected to the second regulator circuit (210); and
wherein the first (208) and second (210) regulator circuits are included in an integrated circuit die and the decoupling capacitor is included in the integrated circuit die.

7. The electronic system of any preceding claim, including fault detection circuitry configured to detect a fault when the electronic system in the sleep mode.

8. A method of operating a circuit supply of an electronic system, the method comprising:
providing energy to gated circuitry (104) using a first circuit supply rail;
providing energy to always-on circuitry (202) using a second circuit supply rail;
regulating the first circuit supply rail using a first regulator circuit (208) directly coupled to the first circuit supply rail;
regulating the second circuit supply rail using a second regulator circuit (210) directly coupled to the second circuit supply rail;
deactivating the first regulator circuit (208) and activating the second regulator circuit (210) in a sleep mode to provide energy to only the always-on circuitry; and
activating the first regulator circuit (208) and a switch circuit (206) coupled between the first circuit supply rail and the second circuit supply rail in an active mode to provide energy to the always-on circuitry and the gated circuitry,
**characterized in that**
the method further comprises, when entering the sleep mode from the active mode, disabling the gated circuitry (104) before disabling the switch circuit (206) and disabling the switch circuit (206) before deactivating the first regulator circuit (208).

9. The method of claim 8, wherein activating the first regulator circuit (208) includes:
detecting when an output of the first regulator circuit (208) reaches a predetermined threshold voltage after activation the first regulator circuit (208); and
activating the switch circuit (206) when the predetermined threshold voltage is reached.

10. The method of claim 8 or claim 9, wherein activating the switch circuit (206) includes shorting an output of the first regulator circuit (208) to an output of the second regulator circuit (210).

11. The method of any of claims 8-10, wherein the regulating the first circuit supply rail includes regulating using a first regulator circuit (208) directly coupled to the first circuit supply rail without a power switch connected between the first regulator circuit (208) and the first circuit supply rail.

## Patentansprüche

1. Elektronisches System, wobei das System Folgendes umfasst:
einen ansteuerbaren Schaltkreis (104);
eine erste Reglerschaltung (208), die direkt mit dem ansteuerbaren Schaltkreis (104) gekoppelt ist;
einen permanent eingeschalteten Schaltkreis (202);
eine zweite Reglerschaltung (210), die direkt mit dem permanent eingeschalteten Schaltkreis (202) gekoppelt ist;
eine Umschaltschaltung (206), die zwischen einem Ausgang der ersten Reglerschaltung (208) und einem Ausgang der zweiten Reglerschaltung (210) gekoppelt ist; und
wobei der permanent eingeschaltete Schaltkreis (202) eine Steuerlogik einschließt, die konfiguriert ist zu Folgendem:
Aktivieren der zweiten Reglerschaltung (210) und Deaktivieren der ersten Reglerschaltung (208) und der Umschaltschaltung (206) in einem Schlafmodus; und
Aktivieren der ersten Reglerschaltung (208) und der Umschaltschaltung (206) in einem aktiven Modus,
**dadurch gekennzeichnet, dass** der permanent eingeschaltete Schaltkreis (202) konfiguriert ist, beim Eintreten in den Schlafmodus aus dem aktiven Modus den ansteuerbaren Schaltkreis (104) zu sperren, bevor die Umschaltschaltung (206) gesperrt wird, und die Umschaltschaltung (206) zu sperren, bevor die erste Reglerschaltung (208) deaktiviert wird.

2. Elektronisches System nach Anspruch 1, das Folgendes einschließt:
einen Erfassungsschaltkreis (212), der erfasst, wenn ein Ausgang der ersten Reglerschaltung (208) eine vorbestimmte Schwellenspannung nach Aktivierung der ersten Reglerschaltung (208) im aktiven Modus erreicht; und
wobei der permanent eingeschaltete Schaltkreis (202) konfiguriert ist, die Umschaltschaltung (206) zu aktivieren, wenn die vorbestimmte Schwellenspannung erreicht wird.

3. Elektronisches System nach einem vorstehenden Anspruch,
wobei die erste Reglerschaltung (208) eine geregelte Spannung für einen ersten Schaltungsversorgungsbereich des elektronischen Systems erzeugt und der ansteuerbare Schaltkreis (104) von dem ersten Schaltungsversorgungsbereich versorgt wird; und
wobei die zweite Reglerschaltung (210) eine geregelte Spannung für einen zweiten Schaltungsversorgungsbereich des elektronischen Systems erzeugt und die permanent eingeschaltete Schaltung (202) im Schlafmodus von dem zweiten Schaltungsversorgungsbereich und im aktiven Modus von dem ersten Schaltungsversorgungsbereich versorgt wird.

4. Elektronisches System nach Anspruch 3, wobei die erste Reglerschaltung (208) direkt mit dem ersten Schaltungsversorgungsbereich ohne einen Leistungsschalter zwischen der ersten Reglerschaltung (208) und dem ersten Schaltungsversorgungsbereich gekoppelt ist.

5. Elektronisches System nach einem vorstehenden Anspruch, wobei die Umschaltschaltung (206) einen inneren Widerstand von einem Ohm aufweist oder wobei die Umschaltschaltung (206) einen inneren Widerstand im Bereich von einem Ohm bis einhundert Ohm aufweist.

6. Elektronisches System nach einem vorstehenden Anspruch, das Folgendes einschließt:
einen Entkopplungskondensator, der mit der zweiten Reglerschaltung (210) verbunden ist; und
wobei die erste (208) und die zweite (210) Reglerschaltung in einem integrierten Schaltungs-Chip eingeschlossen sind und der Entkopplungskondensator im Schaltungs-Chip eingeschlossen ist.

7. Elektronisches System nach einem vorstehenden Anspruch, das einen Fehlererfassungsschaltkreis einschließt, der konfiguriert ist, einen Fehler zu erfassen, wenn das elektronische System sich im Schlafmodus befindet.

8. Verfahren zum Betreiben einer Schaltungsversorgung eines elektronischen Systems, wobei das Verfahren Folgendes umfasst:
Bereitstellen von Energie an einen ansteuerbaren Schaltkreis (104) unter Verwendung einer ersten Schaltungsversorgungsschiene;
Bereitstellen von Energie an einen permanent eingeschalteten Schaltkreis (202) unter Verwendung einer zweiten Schaltungsversorgungsschiene;
Regeln der ersten Schaltungsversorgungsschiene unter Verwendung einer ersten Reglerschaltung (208), die direkt mit der ersten Schaltungsversorgungsschiene gekoppelt ist;
Regeln der zweiten Schaltungsversorgungsschiene unter Verwendung einer zweiten Reglerschaltung (210), die direkt mit der zweiten Schaltungsversorgungsschiene gekoppelt ist;
Deaktivieren der ersten Reglerschaltung (208) und Aktivieren der zweiten Reglerschaltung (210) in einem Schlafmodus, um nur dem permanent eingeschalteten Schaltkreis Energie bereitzustellen; und
Aktivieren der ersten Reglerschaltung (208) und einer Umschaltschaltung (206), die zwischen der ersten Schaltungsversorgungsschiene und der zweiten Schaltungsversorgungsschiene gekoppelt ist, in einem aktiven Modus, um dem permanent eingeschalteten Schaltkreis und dem ansteuerbaren Schaltkreis Energie bereitzustellen,
**dadurch gekennzeichnet, dass** das Verfahren weiter umfasst, beim Eintreten in den Schlafmodus aus dem aktiven Modus den ansteuerbaren Schaltkreis (104) zu sperren, bevor die Umschaltschaltung (206) gesperrt wird, und die Umschaltschaltung (206) zu sperren, bevor die erste Reglerschaltung (208) deaktiviert wird.

9. Verfahren nach Anspruch 8, wobei Aktivieren der ersten Reglerschaltung (208) Folgendes einschließt:
Erfassen, wenn ein Ausgang der ersten Reglerschaltung (208) eine vorbestimmte Schwellenspannung nach Aktivierung der ersten Reglerschaltung (208) erreicht; und
Aktivieren der Umschaltschaltung (206), wenn die vorbestimmte Schwellenspannung erreicht wird.

10. Verfahren nach Anspruch 8 oder Anspruch 9, wobei Aktivieren der Umschaltschaltung (206) einschließt, einen Ausgang der ersten Reglerschaltung (208) mit einem Ausgang der zweiten Reglerschaltung (210) kurzzuschließen.

11. Verfahren nach einem der Ansprüche 8-10, wobei das Regeln der ersten Schaltungsversorgungsschiene das Regeln unter Verwendung einer ersten Reglerschaltung (208) einschließt, die direkt mit der ersten Schaltungsversorgungsschiene gekoppelt ist, ohne einen Leistungsschalter, der zwischen der ersten Reglerschaltung (208) und der ersten Schaltungsversorgungsschiene verbunden ist.

## Revendications

1. Système électronique, le système comprenant :
des circuits à alimentation portillonnée (104) ;
un premier circuit régulateur (208) directement couplé aux circuits à alimentation portillonnée (104) ;
des circuits toujours actifs (202) ;
un deuxième circuit régulateur (210) directement couplé aux circuits toujours actifs (202) ;
un circuit de commutation (206) couplé entre une sortie du premier circuit régulateur (208) et une sortie du deuxième circuit régulateur (210) ; et
dans lequel les circuits toujours actifs (202) incluent une logique de commande configurée pour :
activer le deuxième circuit régulateur (210) et désactiver le premier circuit régulateur (208) et le circuit de commutation (206) dans un mode veille ; et
activer le premier circuit régulateur (208) et le circuit de commutation (206) dans un mode actif,
**caractérisé en ce que** les circuits toujours actifs (202) sont configurés pour, lors de l'entrée dans le mode veille depuis le mode actif, mettre hors service les circuits à alimentation portillonnée (104) avant de mettre hors service le circuit de commutation (206), et mettre hors service le circuit de commutation (206) avant de désactiver le premier circuit régulateur (208).

2. Système électronique selon la revendication 1, incluant :
des circuits de détection (212) qui détectent quand une sortie du premier circuit régulateur (208) atteint une tension de seuil prédéterminée après activation du premier circuit régulateur (208) dans le mode actif ; et
dans lequel les circuits toujours actifs (202) sont configurés pour activer le circuit de commutation (206) quand la tension de seuil prédéterminée est atteinte.

3. Système électronique selon une quelconque revendication précédente,
dans lequel le premier circuit régulateur (208) génère une tension régulée pour un premier domaine d'alimentation de circuit du système électronique et les circuits à alimentation portillonnée (104) sont alimentés par le premier domaine d'alimentation de circuit ; et
dans lequel le deuxième circuit régulateur (210) génère une tension régulée pour un deuxième domaine d'alimentation de circuit du système électronique et les circuits toujours actifs (202) sont alimentés par le deuxième domaine d'alimentation de circuit dans le mode veille et par le premier domaine d'alimentation de circuit dans le mode actif.

4. Système électronique selon la revendication 3, dans lequel le premier circuit régulateur (208) est directement couplé au premier domaine d'alimentation de circuit sans interrupteur d'alimentation entre le premier circuit régulateur (208) et le premier domaine d'alimentation de circuit.

5. Système électronique selon une quelconque revendication précédente, dans lequel le circuit de commutation (206) présente une résistance interne de un ohm, ou dans lequel le circuit de commutation (206) présente une résistance interne dans la plage de un ohm à cent ohms.

6. Système électronique selon une quelconque revendication précédente incluant :
un condensateur de découplage connecté au deuxième circuit régulateur (210) ; et
dans lequel les premier (208) et deuxième (210) circuits régulateurs sont inclus dans une puce de circuit intégré et le condensateur de découplage est inclus dans la puce de circuit intégré.

7. Système électronique selon une quelconque revendication précédente, incluant des circuits de détection de défaut configurés pour détecter un défaut lorsque le système électronique est dans le mode veille.

8. Procédé de fonctionnement d'une alimentation de circuit d'un système électronique, le procédé comprenant :
la fourniture d'énergie à des circuits à alimentation portillonnée (104) à l'aide d'un premier rail d'alimentation de circuit ;
la fourniture d'énergie à des circuits toujours actifs (202) à l'aide d'un deuxième rail d'alimentation de circuit ;
la régulation du premier rail d'alimentation de circuit à l'aide d'un premier circuit régulateur (208) directement couplé au premier rail d'alimentation de circuit ;
la régulation du deuxième rail d'alimentation de circuit à l'aide d'un deuxième circuit régulateur (210) directement couplé au deuxième rail d'alimentation de circuit ;
la désactivation du premier circuit régulateur (208) et l'activation du deuxième circuit régulateur (210) dans un mode veille pour fournir de l'énergie uniquement aux circuits toujours actifs ; et
l'activation du premier circuit régulateur (208) et d'un circuit de commutation (206) couplé entre le premier rail d'alimentation de circuit et le deuxième rail d'alimentation de circuit dans un mode actif pour fournir de l'énergie aux circuits toujours actifs et aux circuits à alimentation portillonnée,
**caractérisé en ce que** le procédé comprend en outre, lors de l'entrée dans le mode veille depuis le mode actif, la mise hors service des circuits à alimentation portillonnée (104) avant de mettre hors service le circuit de commutation (206) et la mise hors service du circuit de commutation (206) avant de désactiver le premier circuit régulateur (208).

9. Procédé selon la revendication 8, dans lequel l'activation du premier circuit régulateur (208) inclut :
la détection du moment où une sortie du premier circuit régulateur (208) atteint une tension de seuil prédéterminée après l'activation du premier circuit régulateur (208) ; et
l'activation du circuit de commutation (206) quand la tension de seuil prédéterminée est atteinte.

10. Procédé selon la revendication 8 ou la revendication 9, dans lequel l'activation du circuit de commutation (206) inclut le fait de court-circuiter une sortie du premier circuit régulateur (208) à une sortie du deuxième circuit régulateur (210).

11. Procédé selon l'une quelconque des revendications 8 à 10, dans lequel la régulation du premier rail d'alimentation de circuit inclut la régulation à l'aide d'un premier circuit régulateur (208) directement couplé au premier rail d'alimentation de circuit sans interrupteur d'alimentation connecté entre le premier circuit régulateur (208) et le premier rail d'alimentation de circuit.
